# FASCICULE DE BREVET EUROPEEN

(11) **EP 1 605 552 B1**
(45) Date de publication et mention de la délivrance du brevet: **09.08.2006**
(21) Numéro de dépôt: 04291455.6
(22) Date de dépôt: 10.06.2004
(51) Int. Cl.: H01R 12/34

(54) **Broche de contact èlectrique portant une charge de soudure et procédé pour sa réalisation**
Kontaktbuchse mit Lötmasse und Herstellungsverfahren
Contact pin with solder mass and method of production

(43) Date de publication de la demande: 14.12.2005
(73) Titulaire: SM Contact, 77860 Quincy Voisins (FR)
(72) Inventeur: Roshardt, Christophe, 77400 Thorigny sur Marne (FR)
(74) Mandataire: Bonnetat, Christian

(56) Documents cités:
- GB-A- 1 060 271
- US-A- 4 802 862

## Description

La présente invention concerne une broche de contact électrique portant une charge de soudure. Elle concerne également un procédé pour la réalisation de ladite broche.

Notamment dans la technique des circuits imprimés, on connaît déjà des broches de contact électrique portant une charge de soudure, permettant de rendre plus aisée et plus fiable la soudure desdites broches sur une plaquette de circuit imprimé pourvue de trous, dans lesquels lesdites broches sont introduites.

De telles broches sont par exemple décrites dans les documents US-3 780 433, US-3 864 014, US-3 977 075, US-4 469 394 et US-A-4 802 862.

Dans ces broches connues, la charge de soudure est rapportée sur lesdites broches, soit par application d'une goutte de soudure fondue, soit par insertion à force, dans des logements longitudinaux, de tronçons de fil de soudure au cours de la réalisation même desdites broches.

De tels processus ne sont pas aisés à mettre en oeuvre et peuvent difficilement être utilisés dans les machines automatiques de production en continu desdites broches.

La présente invention a pour objet de remédier à ces inconvénients.

A cette fin, selon l'invention, la broche de contact électrique portant une charge de soudure, est remarquable en ce que ladite charge de soudure se présente sous la forme d'une bague sertie sur ladite broche, coaxialement à cette dernière.

Le procédé pour la réalisation de la broche selon l'invention est tel que revendiqué dans la revendication 1.

Ainsi, le processus de formation de la charge de soudure sur la broche de contact électrique ne comporte que deux opérations mécaniques (à savoir la mise en place du cavalier autour de la broche et le sertissage dudit cavalier) qui peuvent être aisément incorporés au processus de fabrication des broches par une machine automatique.

Afin d'assurer une bonne prise à la pièce de soudure en forme de cavalier sur la broche, on forme, sur ladite broche, une irrégularité de surface, à l'emplacement auquel ladite pièce de soudure est rapportée et sertie. Une telle irrégularité de surface peut être en creux et/ou en relief et elle est de préférence obtenue par matriçage de ladite broche.

Les figures du dessin annexé feront bien comprendre comment l'invention peut être réalisée. Sur ces figures, des références identiques désignent des éléments semblables.

Les figures 1 et 2 illustrent, en perspective agrandie, un exemple de broche de contact électrique conforme à la présente invention, respectivement avant et après solidarisation de la charge de soudure sur ladite broche.

Les figures 3 et 4 illustrent, en perspective agrandie, un autre exemple de la broche de contact électrique conforme à la présente invention, respectivement avant et après solidarisation de la charge de soudure sur ladite broche.

Les figures 5 et 6 illustrent, en perspective agrandie, un exemple de processus de solidarisation de la broche des figures 2 ou 4 sur une plaquette de circuit imprimé partiellement représentée, respectivement avant et après soudure.

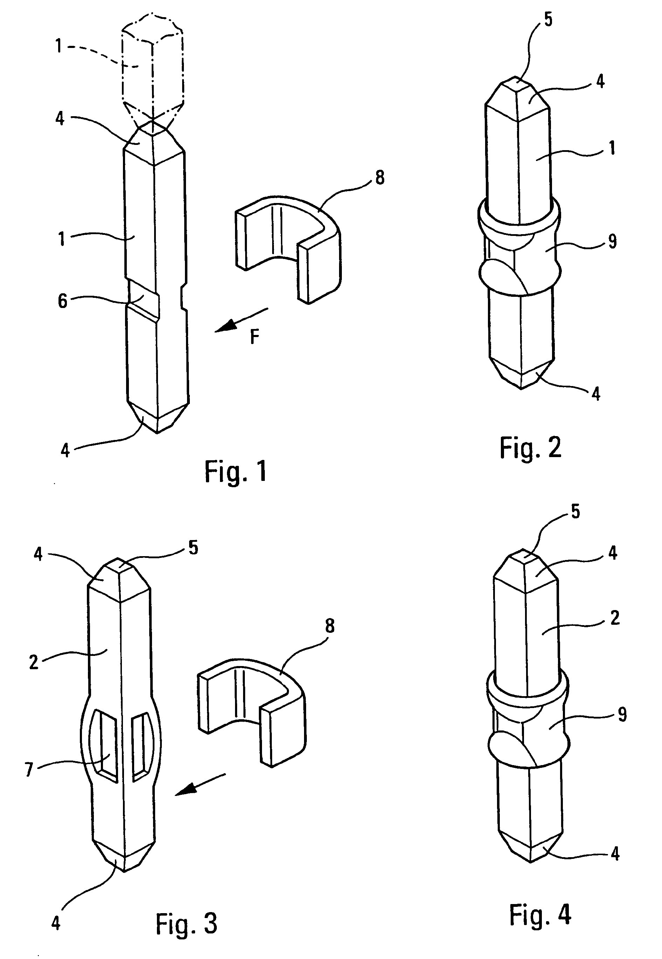

Les broches 1 et 2 de contact électrique, respectivement montrées par les figures 1 et 3, sont par exemple produites, de façon connue, à partir d'un fil continu, dans lequel elles forment une suite ininterrompue, comme cela est illustré en tirets mixtes sur la figure 1. De façon également connue, chaque broche 1 ou 2 de la suite est délimitée, par rapport à la précédente et à la suivante, par des zones de moindre résistance 4 obtenues par matriçage et pouvant être aisément rompues au niveau de sections amoindries 5.

Conformément à une particularité de la présente invention, lors du matriçage des zones 4 de moindre résistance, on matrice également des irrégularités de surface 6 ou 7, en creux et/ou en relief, dans la partie intermédiaire desdites broches 1 ou 2.

Par ailleurs, également conformément à la présente invention, indépendamment de la production desdites broches 1 et 2, on prépare des charges de soudure 8 présentant la forme au moins approximative d'un cavalier.

Ensuite, comme illustré par les flèches F des figures 1 et 3, une charge de soudure 8 en forme de cavalier est rapportée à chaque broche 1 ou 2, autour de celle-ci, au niveau desdites irrégularités de surface en creux 6 et/ou en relief 7.

Après quoi, chaque charge de soudure 8, ainsi rapportée autour desdites irrégularités de surface, est sertie autour de la broche 1 ou 2 correspondante, pour former une bague de soudure 9 en collerette, qui en est solidaire, comme cela est montré par les figures 2 et 4.

On comprendra aisément que la mise en place et le sertissage des charges de soudure 8 sur les broches 1 ou 2 sont deux opérations mécaniques simples, aisées à mettre en oeuvre dans le processus de fabrication desdites broches 1 ou 2.

On remarquera, de plus, que les charges de soudure en forme de cavalier 8 peuvent être formées pour correspondre exactement à la quantité de soudure optimale pour la soudure à effectuer et que l'opération de sertissage est aisée puisque la charge de soudure 8 est constituée par de l'étain ou un alliage métallique analogue et présente donc une grande malléabilité.

Par la mise en oeuvre du procédé selon l'invention, on obtient les broches composites 1, 9 ou 2, 9, respectivement illustrées par les figures 2 et 4.

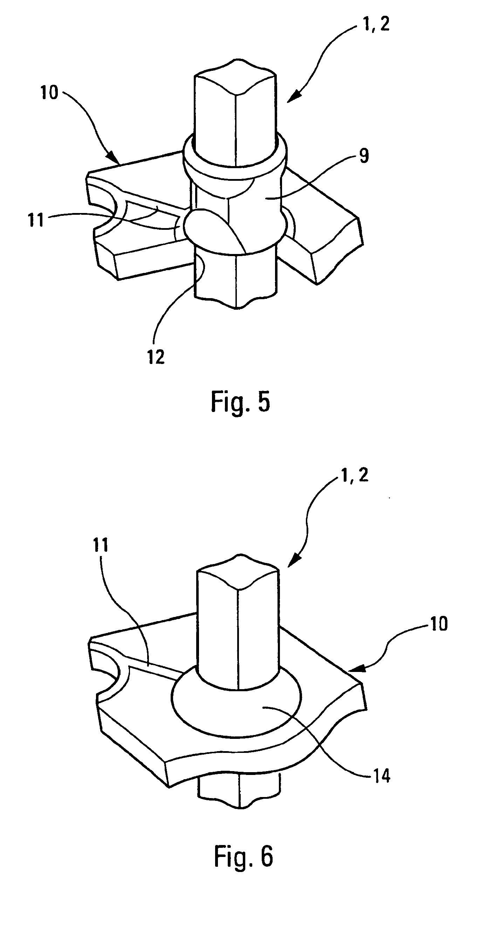

Sur les figures 5 et 6, on a illustré la soudure de ces broches composites sur une plaquette de circuit imprimé 10, portant des pistes conductrices 11, reliées à un trou métallisé 12.

Dans l'exemple représenté, la broche composite 1, 9 ou 2, 9 est introduite dans le trou métallisé 12 jusqu'à ce que la bague de soudure 9 vienne au contact de ladite plaquette 10. Bien entendu, la bague de soudure 9 et le trou métallisé 12 pourraient être prévus pour que ladite bague pénètre dans ledit trou.

A partir de cette position, illustrée par la figure 5, on déclenche un processus thermique apte à fondre la bague de soudure 9, pour former la soudure 14 de ladite broche 1, 2 sur la plaquette 10.

De ce qui précède, on comprendra aisément que les broches composites 1, 9 et 2, 9 peuvent être produites de façon économique et fiable, notamment du fait que l'apport de la charge de soudure par sertissage sur chaque broche peut se faire en sortie de la machine de matriçage et au même rythme, sans pénaliser en conséquence la cadence de production des broches.

Livrées par exemple en bobines continues, les broches composites à charge de soudure selon l'invention sont d'un emploi aussi souple que les broches usuelles sans charge, et leur implantation s'effectue avec les machines d'insertion existantes.

Bien entendu, la présente invention n'est pas limitée à des broches fabriquées en suite continue : les broches composites 1, 9 et 2, 9 peuvent en effet se présenter en vrac, en dérivation sur une bande porteuse, ou encore toute autre forme de présentation connue dans la technique.

De plus, bien que ci-dessus on ait décrit la présente invention plus spécialement en rapport avec des broches de dispositifs de connexion, il va de soi qu'elle n'est pas limitée à ce type de broche, mais que, au contraire, elle peut s'appliquer à d'autres types, comme par exemple les broches constituées par les pattes de connexion des composants électroniques.

## Revendications

1. Procédé pour la réalisation d'une broche de contact électrique (1,2) portant une charge de soudure (9),
**caractérisé en ce que** :
- on réalise ladite broche (1,2) indépendamment de ladite charge de soudure (9) ;
- indépendamment de la réalisation de ladite la broche (1,2), on réalise ladite charge de soudure (9) sous la forme d'une pièce (8) présentant au moins approximativement la forme d'un cavalier ; puis
- on rapporte ladite pièce (8) en forme au moins approximative de cavalier à ladite broche (1,2), de façon que ladite pièce (8) soit disposée autour de ladite broche (1,2) ; après quoi
- on sertit ladite pièce (8) autour de ladite broche (1,2) pour former une bague (9) fixée fermement à ladite broche, coaxialement à celle-ci.

2. Procédé selon la revendication 1,
**caractérisé en ce qu'**on forme, sur ladite broche (1, 2), une irrégularité de surface (6, 7), à l'emplacement auquel ladite pièce de soudure (8) est rapportée et sertie.

3. Procédé selon la revendication 2,
**caractérisé en ce que** ladite irrégularité de surface (6) est en creux.

4. Procédé selon la revendication 2,
**caractérisé en ce que** ladite irrégularité de surface (7) est en relief.

5. Procédé selon l'une des revendications 2 à 4,
**caractérisé en ce que** ladite irrégularité de surface (6, 7) est obtenue par matriçage.

## Claims

1. A process for producing an electrical contact pin (1, 2) carrying a charge of solder (9),
**characterized in that**:
- said pin (1, 2) is produced independently of said charge of solder (9);
- independently of the producing of said pin (1, 2), said charge of solder (9) is produced in the form of a piece (8) having at least approximately the shape of a staple;
- said piece (8) having at least approximately the shape of a staple is joined to said pin (1, 2) in such a way that said piece (8) is disposed around said pin (1, 2); after what
- said piece (8) is crimped around said pin (1, 2) in order to form a ring (9) firmly fixed to said pin, coaxially to this latter.

2. The process as claimed in claim 1,
**characterized in that** a surface irregularity (6, 7) is formed on said pin (1, 2) at the place where said piece of solder (8) is attached and crimped.

3. The process as claimed in claim 2,
**characterized in that** said surface irregularity (6) is in the form of a recess.

4. The process as claimed in claim 2,
**characterized in that** said surface irregularity (7) is in the form of a raised feature.

5. The process as claimed in one of claims 2 to 4,
**characterized in that** said surface irregularity (6, 7) is obtained by stamping.

## Patentansprüche

1. Verfahren zur Herstellung eines elektrischen Kontaktstifts (1, 2) mit einer Lötmasse (9),
**dadurch gekennzeichnet, dass**:
- der Stift (1, 2) unabhängig von der Lötmasse (9) hergestellt wird;
- unabhängig von der Herstellung des Stifts (1, 2) die Lötmasse (9) in Form eines Teils (8) gebildet wird, das wenigstens annähernd die Form eines Reiters aufweist;
- das wenigstens annähernd die Form eines Reiters aufweisende Teil (8) derart an dem Stift (1, 2) angebracht wird, dass das Teil (8) um den Stift (1, 2) herum angeordnet ist; und danach
- das Teil (8) um den Stift (1, 2) herum aufgequetscht wird, um einen Ring (9) zu bilden, der fest an dem Stift fixiert ist, und zwar koaxial zum Letztgenannten.

2. Verfahren nach Anspruch 1, **dadurch gekennzeichnet, dass** an dem Stift (1, 2) eine Oberflächenunregelmäßigkeit (6, 7) gebildet wird, an deren Ort das Lötteil (8) angebracht und aufgequetscht wird.

3. Verfahren nach Anspruch 2, **dadurch gekennzeichnet, dass** die Oberflächenunregelmäßigkeit (6) als Vertiefung vorliegt.

4. Verfahren nach Anspruch 2, **dadurch gekennzeichnet, dass** die Oberflächenunregelmäßigkeit (7) als Erhöhung vorliegt.

5. Verfahren nach einem der Ansprüche 2 bis 4, **dadurch gekennzeichnet, dass** die Oberflächenunregelmäßigkeit (6, 7) durch Prägen erzielt wird.
